# EUROPEAN PATENT APPLICATION

(11) **EP 1 186 353 A2**
(43) Date of publication of application: **13.03.2002**
(21) Application number: 01307614.6
(22) Date of filing: 07.09.2001
(51) Int. Cl.: B08B 7/00, B08B 9/08

(54) **Treatment of gas cylinders**

(30) Priority: 08.09.2000 US 657957
(71) Applicant: THE BOC GROUP, INC., Murray Hill, New Providence, New Jersey 07974-2082 (US)
(72) Inventor: Jansen, Frank, San Jose, California 95132 (US); Hogle, Richard Allen, Oceanside, California 92056 (US); Paciej, Richard C, Gladstone, New Jersey 07934 (US); Ezell, Edward Frederick, Warren, New Jersey 07059 (US); Belkind, Abraham I, North Plainfield, New Jersey 07060 (US); Stockman, Paul Alan, Neshanic Station, New Jersey 08854 (US); Cross, Kenneth William, Cardiff, California 92007 (US); Doxstader, Roy Edwin, Oceanside, california 92056 (US)
(74) Representative: Bousfield, Roger James

(57) **Abstract**

A process for treating a compressed gas cylinder (70) comprising introducing a gas into said cylinder and applying a current to said gas to create a plasma in the cylinder for a sufficient time to clean and/or passivate the interior cylinder surface.

## Description

This invention relates to the treatment of gas cylinders and in particular provides for a process for cleaning and passivating a compressed gas cylinder using a cleaning gas and a power supply to create a plasma in the cylinder.

The cleanliness standards for gases continue to rise steadily. This is particularly true for those gases used in the electronics industry. The delivery systems for these gases are primarily gas cylinders and the focus is primarily upon gas cylinder cleaning and preparation.

Moisture contamination is a major source of contamination of clean electronic gases. Cylinder bake-out is employed in vacuum to remove residual water and is currently the last cleaning step employed in current cleaning procedures. The water removal by bake-out to very low water vapour pressures requires a long time, typically 2 to 3 hours. This adds to the expense of cylinder cleaning as higher concentrations of water will require longer bake-out times at higher temperatures.

After the bake-out step, post-treatment cleaning is performed. This is typically passivation of the interior surface of the gas cylinder with a reactive gas. Again this adds to the expense of cleaning and preparing the cylinders for use.

It has now been discovered that the use of a plasma generated inside the gas cylinder provides improved removal of moisture. The further backfilling with an inert gas eliminates the need for additional treatment and aids in reducing the loss of cleaning and preparing gas cylinders for use in the electronics gas industry.

In accordance with the invention, there is provided a process for treating a compressed gas cylinder comprising introducing a gas into said cylinder and applying a current to said gas to create a plasma in the cylinder for a sufficient time to clean and/or passivate the interior cylinder surface.

The invention therefore provides for a process for plasma cleaning, especially drying, and for passivating compressed gas cylinders which have been discharged of their appropriate gas. The process comprises applying a plasma gas to the inside of the cylinder to be cleaned and applying a current to the gas for a time sufficient to clean and/or passivate the interior cylinder surface.

In preferred embodiments, the process may further comprise the steps of connecting the empty cylinder to a flange which has a centre opening which allows for insertion of a metal tube through the flange and into the cylinder; connecting a vacuum source to the flange; attaching a source of plasma gas to the metal tube; inserting an anode electrode through the metal tube and connecting a power supply to the anode electrode; starting the flow of plasma gas into the cylinder and applying current to the anode electrode; continuing the flow of gas and current until the cylinder is cleaned (in particular free of moisture) and/or passivated.

This process offers advantages over the traditional bake-out method of drying a cylinder. Since the plasma concentrates on the surface of the cylinder, as opposed to heating the bulk of the cylinder, it is a more efficient process. Additional energy can be supplied to the surface by bombarding molecules such as argon or by using chemical reactions such as with hydrogen in removing the oxides on the surface. This chemistry cannot occur using a bake-out process.

By using DC or AC type plasma methods, customised plasmas can be designed to remove specific impurities, as opposed to a bake-out process which can only remove volatile impurities. For example, organics can be removed by oxygen plasma and hydrogen or fluorine plasmas can remove oxygen. Further, the metal surface can be sputtered away to expose a fresh surface of metal which cannot be done in a bake-out process.

Further efficiencies are realised in that a plasma system can operate around 1 torr while vacuum levels during bake-out need to be on the order of 10⁻⁴ torr to remove moisture. The steady flow of the high purity gas through the cylinder from top to bottom allows impurities to be swept effectively from the cylinder and accelerates cleaning.

For a better understanding of the invention, reference will now be made, by way of exemplification only, to the accompanying drawings, in which:
Figure 1 is an overview of the plasma gas process.
Figure 2 is a graph of amount of water present versus time for plasma treatment of a cylinder and bake-out treatment of a cylinder.

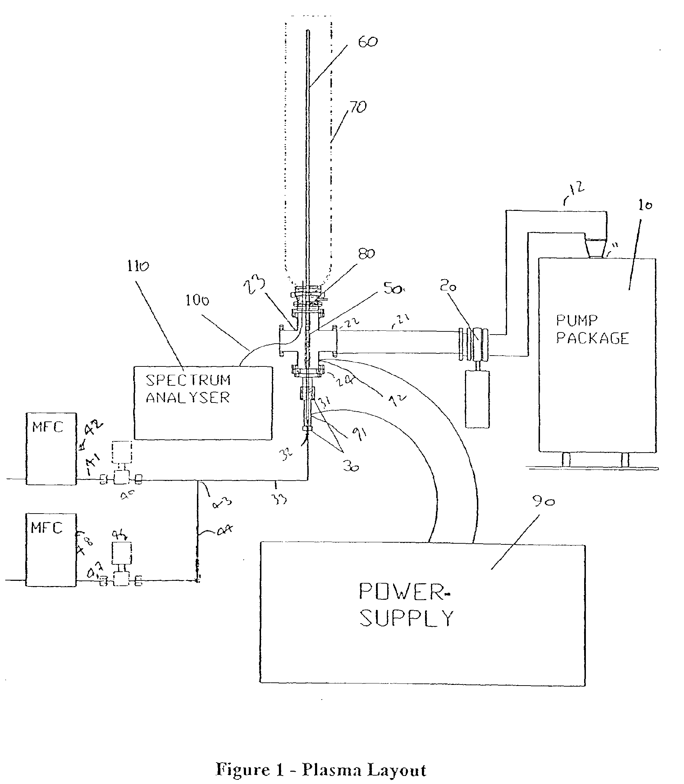

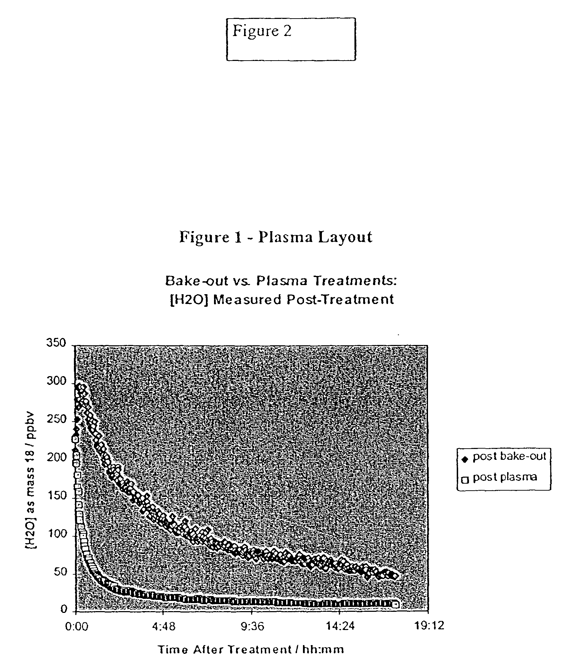

With reference to Figure 1, a plasma treatment system 1 is shown and includes a pump package 10 which connects through a valve 11 to a tube 12. This tube 12 connects to control valve 20. This control valve 20 is suitably sized to handle flow rates and pressures encountered in the process. The control valve 20 attaches to a tube 21 which connects a flange 22 to a four-way cross 23.

The cylinder 70 which is to be dried and/or passivated connects via a flange assembly 80 to the four-way cross assembly 23. When the flange is engaged to the cylinder, a vacuum can be drawn on the cylinder. Typically, a vacuum in the range of 10 torr to about 0.1 torr is employed in the drying and for passivation of the cylinder.

An anode electrode 60 is introduced through the vacuum feed-through a flange 24 and through a flange assembly 80 into the cylinder 70. An insulator 50 surrounds the anode electrode within the four-way cross assembly 23 so that no plasma energy is released within the four-way valve assembly.

Vacuum feed-throughs 30 and 31 attach to the anode electrode 60 so as electronically to isolate the anode electrode from the entire plasma treatment systems and a gas feed tube 33. A plasma power supply 90 which can be either AC or DC connects to an anode electrode at 91 and to the four-way cross assembly at 92. Connection can be made by a clamping device or soldering of the power leads to the respective connection points.

Feed tube 33 connects to the anode electrode 60 at fitting 32. The feed tube 33 further connects to a valve 40 which connects via line 41 to the gas supply Mass Flow Controller (MFC) 42. The feed tube 33 also connects to a manifold 43 which connects to a tube 44 which connects further with a valve 46 and further through a line 47 to a gas supply MFC 48. Several other feed gas supply lines can be connected to this manifold in a similar manner. The gas cylinder will typically contain a gas comprising one or more of argon, helium, hydrogen, nitrogen, oxygen, neon and krypton. The gases that can be employed as the plasma gas include but are not limited to one or more of oxygen, hydrogen bromide, bromine, chlorine, CIF₃, nitrogen trifluoride, freons, sulphur hexafluoride, BCl₃ and HCI.

The plasma treatment system operates by establishing a vacuum in the system and a flow of the plasma gas into the cylinder. The power is then supplied to the anode electrode and a plasma is created within the cylinder. The plasma can be controlled to provide a variety of conditions. For example, argon can be employed and a sputtering condition created so that the cylinder is bombarded with inert atoms to clean off specific impurities. Other conditions can be created where the surface of the cylinder is chemically modified by the introduction of NF₃, hydrogen bromide, bromine, chlorine, BC1₃ or other reactive gases to chemically convert the surface of the cylinder to a chemical condition appropriate for the gas to be placed in the cylinder later. Typically, flow rates for these gases into the centre of the tube ranges from about 0.5 to about 5.0 slm.

In one embodiment of the invention, a fibre optic probe 100 is employed to look at the emissions coming from the plasma in the cylinder. The spectrum of this emission can be analysed to detect the presence of moisture and other gases being generated during the plasma process and to monitor the progress of the passivation and/or drying of the cylinder using the spectrum analyser 110. Based on the spectrum analyser data, once a specific condition has been achieved, the plasma process can be discontinued.

In another implementation of the process, the low pressure exhaust gas from the process is passed through an FT-IR, moisture analyser, laser ringdown analyser, tunable diode laser analyser, Residual Gas Analyser (RGA), intracavity laser analyser or other spectroscopic analyser before going to the pumping system and the progress and completion of the drying and/or passivation process is determined based on this spectral information.

An experiment was performed with the plasma process using argon for the removal of moisture from cylinders. 400 cc per minute of argon were passed through the system and the vacuum pump established a 1 torr pressure in the cylinder. Plasma was struck using a DC plasma power supply with 2.5 ampere and 250 volt settings. The plasma process was operated for approximately 2 hours on the cylinder.

Once the plasma was completed, the cylinder was then filled with high purity nitrogen at a rate of one litre per minute. An atmospheric pressure ionisation mass spectrometer (APIMS) was used to measure the moisture levels coming from the cylinder. Comparatively, a cylinder was baked-out using a turbo molecular vacuum pump and a heating blanket at a temperature of 130° F and 10⁻⁶ torr pressure and the moisture levels of dry nitrogen passing through the cylinder were checked with the APIMS spectrometer.

The cylinder cleaning and test protocol that was employed for both the plasma cleaning and bake-out cleaning is outlined below. Those steps designated with an "a" are for the plasma and those steps designated with a "b" are for the bake-out.
1. Cylinder dried to 10 ppb with 2 slm **N**₂
2. Evacuated briefly with a roots blower for 15 seconds at 2 mTorr
3. Filled with wet **N**₂ (dew point 3.4C = 7700 ppm H₂O) to 800 torr and let sit for 1 hour
4. Evacuated briefly
5a. Filled and maintained with Ar at 1 torr and 200 sccm
5b. Pumping switched to turbo pump
6a. Plasma treated for 2 hours
6b. Heated to 110° C and held for 2 hours
7a. Evacuated briefly
7b. Pumping switched to roots blower
8. Filled with dry **N**₂ to 800 torr
9. Evacuated briefly
10. Filled with dry **N**₂ to 900 torr
11. Maintained at 900 torr and 2 slm **N**₂ stream analysed by APIMS

Figure 2 shows that the moisture leaving the cylinder after plasma treatment was considerably lower than that of the bake-out treatment. As shown in Figure 2, the amount of moisture coming out of the plasma process treated cylinder was less than one tenth the total amount of moisture coming out of the baked-out cylinder. The dry-out curve was also much steeper for the plasma process, which indicates that residual moisture was depleted in the cylinder treated by the plasma process much more rapidly.

Based on the treatment times for the two processes, the plasma process produced a much lower moisture level. It is anticipated that a shorter period of time using the plasma process would be sufficient for removing significant levels of moisture compared to the bake-out process.

Once the plasma process is completed, the system can be back-filled with an ultra-dry inert gas to ensure that the modified chemistry is not affected by the introduction of air. The valve is inserted into the neck by several possible means. A glove box can be attached to the system to allow for insertion of the valve under an inert environment. A mechanical manipulator within the vacuum system can be used to insert the valve and/or inert gas environment can be established around the exit of the cylinder so that a valve can be inserted externally while maintaining the purity of the cylinder's contents. Once a valve is inserted, it can be tightened by standard means and subject to standard leak test procedures. The cylinder is then fully removed and is ready for filling with an appropriate gas

## Claims

1. A process for treating a compressed gas cylinder comprising introducing a gas into said cylinder and applying a current to said gas to create a plasma in the cylinder for a sufficient time to clean and/or passivate the interior cylinder surface.

2. A process according to Claim 1 in which the gas comprises one or more of argon, helium, hydrogen, nitrogen, oxygen, neon and krypton.

3. A process according to Claim 1 or Claim 2 in which the current is alternating or direct.

4. A process according to any preceding claim in which the cylinder is under vacuum.

5. A process according to any preceding claim in which the flow rate of the gas ranges from about 0.5 slm to about 5.0 slm.

6. A process according to any preceding claim in which the cylinder is back-filled with an inert gas subsequent to the removal of moisture.

7. A process according to any preceding claim in which the passivation is performed with a gas comprising one or more of oxygen, hydrogen bromide, bromine, chlorine, CIF₃, nitrogen trifluoride, freon, sulphur hexachloride, BCl₃ and HCI.

8. A process according to any preceding claim further comprising sputtering the interior surface of the cylinder.

9. A process for cleaning and/or passivating a compressed gas cylinder comprising the steps of:
a) connecting the cylinder to a flange having an opening;
b) inserting a metal tube through the opening and into the cylinder;
c) connecting a vacuum source to the flange;
d) inserting an anode electrode through the metal tube;
e) connecting a power supply to the anode electrode;
f) starting a flow of a gas through the metal tube and into the cylinder;
g) applying current to the anode electrode to create a plasma in the cylinder for a time sufficient to clean and/or passivate the cylinder.

10. A process according to Claim 9 in which the vacuum source provides from about 10 torr to about 0.1 torr vacuum to the cylinder.
